# EUROPÄISCHE PATENTSCHRIFT

(11) **EP 1 286 335 B1**
(45) Veröffentlichungstag und Bekanntmachung des Hinweises auf die Patenterteilung: **27.02.2008**
(21) Anmeldenummer: 02102145.6
(22) Anmeldetag: 16.08.2002
(51) Int. Cl.: G11B 5/03

(54) **Schaltungsanordnung zur Steuerung eines magnetoresistiven Sensors**
Driver circuit for a magnetoresistive sensor
Circuit d'attaque pour un capteur magnétorésistif

(30) Priorität: 17.08.2001 DE 10140517
(43) Veröffentlichungstag der Anmeldung: 26.02.2003
(73) Patentinhaber: NXP B.V., 5656 AG Eindhoven (NL)
(72) Erfinder: Muth, Michael Philips Corporate Int. Property GmbH, 52088, Aachen (DE); Harmansa, Adrian Philips Corp. Int. Property GmbH, 52088, Aachen (DE)
(74) Vertreter: Volmer, Georg

(56) Entgegenhaltungen:
- EP-A- 0 866 453
- US-A- 5 390 054
- PATENT ABSTRACTS OF JAPAN vol. 1997, no. 03, 31. März 1997 (1997-03-31) & JP 08 297806 A (HITACHI LTD), 12. November 1996 (1996-11-12)
- PATENT ABSTRACTS OF JAPAN vol. 1997, no. 07, 31. Juli 1997 (1997-07-31) & JP 09 073620 A (HITACHI LTD), 18. März 1997 (1997-03-18)

## Beschreibung

Die Erfindung betrifft eine Schaltungsanordnung zur Steuerung eines Sensors mit einer Versorgungsspannungsquelle, die mit Eingangsanschlüssen des Sensors verbunden ist, und eine Auswerteschaltung, die mit Ausgangsanschlüssen des Sensors verbunden ist , wobei die Versorgungsspannungsquelle zwischen wenigstens zwei Strompegeln in Abhängigkeit eines Ausgangssignals des Sensors umschaltbar ist. Ferner betrifft die Erfindung einen die Schaltungsanordnung aufweisenden Sensor.

Schaltungsanordnungen der gattungsgemäßen Art sind bekannt.

Die hier angesprochenen passiven Sensoren umfassen zunächst beispielsweise wenigstens einen magnetoresistiven Widerstand, der mit einer Versorgungsspannung beaufschlagbar ist. Bei Einwirkung eines externen Magnetfeldes auf den magnetoresistiven Widerstand ändert dieser seinen Widerstandswert, so dass es zu einer Änderung der Ausgangsspannung des magnetoresistiven Sensors kommt. Diese Änderung der Ausgangsspannung ist über eine Auswerteschaltung erfassbar und ein entsprechendes Ereignissignal generierbar.

Einsatz finden derartige magnetoresistive Sensoren beispielsweise bei einer Winkelmessung oder Wegmessung. Bei verschiedenen Anwendungsfällen erfolgt hierbei keine kontinuierliche Messung, sondern eine gegebenenfalls in großen Zeitabständen erfolgende - diskontinuierliche - Messung. Um jedoch auch zu den diskontinuierlichen Zeitpunkten - die gegebenenfalls nicht bekannt sind - die volle Funktionsfähigkeit der magnetoresistiven Sensoren zu gewährleisten, sind diese ständig mit der Versorgungsspannungsquelle verbunden. Hierbei ist zunächst nachteilig, dass zum Aufrechterhalten eines hohen Ausgangssignalpegels des magnetoresistiven Sensors eine relativ hohe Versorgungsspannung anliegt, die zu einem entsprechend hohen Stromfluss führt. Bekannte magnetoresistive Sensoren besitzen beispielsweise einen Widerstandswert von 5 kΩ. Dies würde bei einer angenommenen Versorgungsspannung von 5 V zu einem Stromfluss von 1 mA führen. Dieser Strom fließt auch dann, wenn sich das magnetoresistive Sensorelement lediglich in einem Bereitschaftszustand befindet.

Eine Schaltungsanordnung der eingangs genannten Art offenbart beispielsweise das Patent US-A-5 390 054.

In dem US-A-5 390 054 wird jedoch nicht die Notwendigkeit von "Aufweckfunktionen" thematisiert, d. h. die Erfassung beispielsweise einer Winkeländerung oder -bewegung mit einer geringen Stromaufnahme des Sensors. Ein nahe liegender Weg, derartige "Aufweckfunktionen" zu realisieren, ist sicherlich die Entwicklung besonders hochohmiger Sensoren. Allerdings müssten dann die MR-Sensoren über extrem dünn ausgeführte MR-Strukturen verfügen oder das Layout der MR-Sensoren besonders fein strukturiert sein. Diese Strukturen sind jedoch technologisch nur unter großem Aufwand realisierbar. Auch sind MR-Sensoren mit dünnen Strukturen ungenau, da sie das Rauschen erhöhen.

Der vorliegenden Erfindung liegt daher die Aufgabe zugrunde, eine Schaltungsanordnung der gattungsgemäßen Art zur Verfügung zu stellen, bei der eine erste Bewegung unter geringer Stromaufnahme detektiert und somit das gesamte System "geweckt" wird, das dann einen wesentlich höheren Strom aufnehmen und somit wesentlich genauer arbeiten kann.

Diese Aufgabe wird durch eine Schaltungsanordnung mit den Merkmalen des Anspruchs 1 gelöst.

Dadurch, dass die Versorgungsspannungsquelle zwischen wenigstens zwei Strompegeln in Abhängigkeit eines Ausgangssignalpegels des Sensors umschaltbar ist, wird zunächst vorteilhaft erreicht, dass trotz zunächst erfolgender Beaufschlagung des Sensors mit einer niedrigeren Versorgungsspannung dieser seine Sensierfunktion während des Bereitschaftszustandes beibehält. Die Beaufschlagung mit einer niedrigeren Versorgungsspannung führt zwar zu einer Verringerung eines Ausgangssignalpegels des Sensors, jedoch reicht dieser geringere Ausgangssignalpegel aus, um die Annäherung eines zu detektierenden Ereignisses, beispielsweise eines externen Magnetfeldes, beispielsweise bei einer Winkelmessung oder Wegmessung, zu erkennen. Wird diese Annäherung des zu detektierenden Ereignisses erkannt, erfolgt eine Umschaltung auf eine höhere Versorgungsspannung (Standardversorgungsspannung), womit die Soll-Ausgangsspannung des Sensors unmittelbar gewährleistet ist. Es wird deutlich, dass zunächst die Erfassung beispielsweise einer Winkeländerung oder -bewegung mit einer geringen Stromaufnahme des Sensors erfolgen kann, ohne die volle Funktionstätigkeit des Sensors während dessen eigentlicher Messung zu beeinträchtigen. Insbesondere ist hierbei zunächst vorteilhaft, dass am Sensorelement selber keinerlei Layoutänderungen zur Realisierung dieser Bereitschaftsfunktion vorgenommen werden müssen, so dass Standardsensoren einsetzbar sind.

Zudem ist gemäß der Erfindung vorgesehen, dass die Versorgungsspannungsquelle über einen Umschalter mit dem Sensor verbunden ist, wobei ein Steueranschluss des Umschalters von der Auswerteschaltung des Sensors ansteuerbar ist. Hierdurch wird zunächst in einfacher Weise eine Verknüpfung der Umschaltung der Versorgungsspannungsquelle zwischen wenigstens zwei Strompegeln und der Auswerteschaltung möglich. Insbesondere kann so sofort nach Erkennen eines zu detektieren Ereignises unmittelbar die Umschaltung der Versorgungsspannungsquelle auf den höheren Strompegel und somit die Anhebung des Ausgangssignalpegels des Sensors realisiert werden. Weiterhin ist vorgesehen, dass die Auswerteschaltung mindestens zwei Messkanäle unterschiedlicher Empfindlichkeit umfasst, wobei ein Messkanal in Form eines Hochpassfilters vorliegen kann und mit niedriger Empfindlichkeit der Ansteuerung des der Versorgungsspannungsquelle zugeordneten Umschalters dient. Hierdurch wird erfindungsgemäß erreicht, den Sensor zunächst mit einem für die Erkennung der Bewegung ausreichenden Mindestausgangssignalspegel zu versehen. Gemäß der Erfindung wird somit eine Art Aufweckfunktion realisiert, die eine erste Bewegung detektiert und somit das Gesamtsystem weckt. Auf diese Weise ist gewährleistet, dass das System einen wesentlich höheren Strom aufnehmen darf, mit der Folge, dass dieses dann auch wesentlich genauer arbeitet.

Insbesondere, wenn in weiterer bevorzugter Ausgestaltung der Erfindung vorgesehen ist, dass der Meßkanal mit niedriger Empfindlichkeit gleichzeitig der Umschaltung der Auswerteschaltung auf einen Meßkanal höherer Empfindlichkeit dient, wird in einfacher Weise sichergestellt, dass bei Erkennen eines Ereignisses der Sensor neben seiner Umschaltung der Spannungsversorgung auf einen höheren Strompegel gleichzeitig in seiner Sensierempfindlichkeit angehoben wird. Somit ist trotz einer im Bereitschaftszustand (sleep mode) realisierten geringen Stromaufnahme im Betriebszustand eine sofortige volle Funktionsfähigkeit des Sensors mit dem gewünschten hohen Ausgangssignalpegel des Sensors sichergestellt.

Darüber hinaus ist in bevorzugter Ausgestaltung der Erfindung vorgesehen, dass der erste Umschalter zum Umschalten der Versorgungsspannungsquelle und der zweite Umschalter zum Umschalten der Meßkanäle der Auswerteschaltung von einem gemeinsamen Auslösemittel angesteuert werden, das vorzugsweise als Schmitt-Trigger ausgebildet ist. Hierdurch wird die Verknüpfung der Umschaltung der Versorgungsspannungsquelle mit der Umschaltung der Ausgangsschaltung durch geringe schaltungstechnische Maßnahmen möglich.

Weitere bevorzugte Ausgestaltungen der Erfindung ergeben sich aus den übrigen, in den Unteransprüchen genannten Merkmalen.

Die Erfindung wird nachfolgend in einem Ausführungsbeispiel anhand der zugehörigen Zeichnung die ein Blockschaltbild einer Schaltungsanordnung eines magnetoreisistiven Sensors zeigt, näher erläutert.

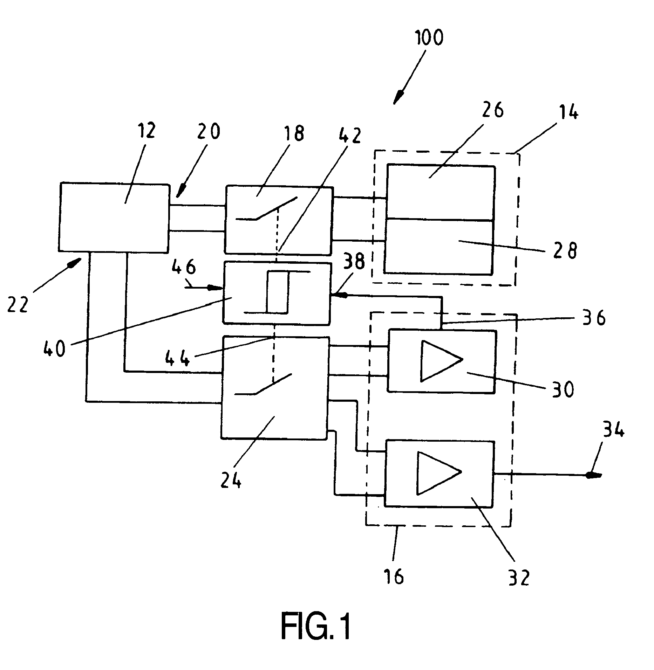

Die Figur zeigt eine Schaltungsanordnung 100 zur Steuerung eines magnetoresistiven Sensors 12. Die Schaltungsanordnung 100 umfaßt eine Versorgungsspannungsquelle 14 sowie eine Auswerteschaltung 16.

Die Vetsorgungspannungsquelle 14 ist über einen ersten Umschalter 18 mit Eingangsanschlüssen 20 des magnetoresistiven Sensors 12 verbunden. Ausgangsanschlüsse 22 des magnetoresistiven Sensors 12 sind über einen zweiten Umschalter 24 mit der Auswerteschaltung 16 verbunden.

Die Versorgungsspannungsquelle 14 umfaßt eine erste Stromquelle 26 und eine zweite Stromquelle 28, wobei die Stromquelle 26 einen gegenüber der Stromquelle 28 niedrigeren Versorgungsstrom bereitstellt. Ein Versorgungsstrom I_{V} der Stromquelle 26 beträgt beispielsweise 10 µA Ein Versorgungsstrom I_{V} der Stromquelle 28 beträgt beispielsweise 1 mA. Ein Widerstand des magnetoresistiven Sensors 12 wird beispielsweise mit 10 kΩ angenommen.

Die Auswerteschaltung 16 umfaßt einen ersten Meßkanal 30 und einen zweiten Meßkanal 32. Der Meßkanal 30 umfaßt einen Verstärker mit integriertem Hochpaßfilter. Der Meßkanal 32 umfaßt einen Präzisionsverstärker und ist mit einem Signalanschluß 34 verbunden

Ein Ausgangsanschluß 36 des Meßkanals 30 ist mit einem Eingangsanschluß 38 eines Auslösemittels 40 verbunden. Das Auslösemittel 40 ist beispielsweise ein Schmitt-Trigger. Das Auslösemittel 40 ist mit Steueranschlüssen 42 bzw. 44 der Umschalter 18 bzw. 24 verbunden.

Die in der Figur dargestellte Schaltungsanordnung 100 zeigt folgende Funktion:

Im Bereitschaftszustand (sleep mode) des magnetoresistiven Sensors 12 sind dessen Eingangsanschlüsse 20 über den Umschalter 18 mit der Stromquelle 26 verbunden. Gleichzeitig sind die Ausgangsanschlüsse 22 über den Umschalter 24 mit dem Meßkanal 30 verbunden. In diesem Schaltzustand wird der magnetoresistive Sensor 12 mit einem niedrigeren Versorgungsstrom I_{V} von beispielsweise 10 µA gespeist. Bei einem Widerstand des magnetoresistiven Sensors 12 von 10 kΩ ergibt sich eine Versorgungsspannung U_{V} von 100 mV. Unter Berücksichtigung einer Empfindlichkeit des magnetoresistiven Sensors 12 von 12 mV/V ergibt sich ein Ausgangssignal S = 12 mV/V x 0,1 V =1,2 mV. Das Ausgangssignal mit dieser Signalamplitude liegt über dem Umschalter 24 am Meßkanal 30 an. Dieses Ausgangssignal des Sensors 12 im Bereitschaftszustand wird über die integrierten Hochpaßfilter geführt, so dass die sich nicht durch eine zu detektierende Bewegung ergebenden Signaländerungen, beispielsweise von Driftsignalen eines Offsets des Sensors 12, kompensiert werden können. Dies ist insbesondere auch dadurch möglich, da eine zu detektierende Bewegung eine Mindestgeschwindigkeit aufweisen muß, so dass durch Führen des Signals durch einen Hochpaßfilter sehr gut zwischen dieser Mindestgeschwindigkeit und eventuellen Signaldriften unterschieden werden kann.

Wird von dem magnetoresistiven Sensor 12 eine zu detektierende Belegung erkannt, führt dies zu einer relativ schnellen Änderung des Signalpegels des Ausgangssignals S des Sensors 12. Über den Meßkanal 30 wird dieses Signal an das Auslösemittel 40 weitergegeben. Überschreitet die Signalamplitude einen vorgebbaren Schwellwert, werden über das Auslösemittel 40 die Umschalter 18 und 24 ausgelöst, so dass die Versorgungsspannungsquelle 14 auf die Stromquelle 28 und die Auswerteschaltung 16 auf den Meßkanal 32 umschalten. Hierdurch wird der magnetoresistive Sensor 12 mit einem höheren Strompegel gespeist, so dass der Ausgangssignalpegel des Sensors 12 dem gewünschten Wert entspricht. Dieser Schaltzustand der Schaltungsanordnung 100 entspricht dem Betriebszustand Ein entsprechendes, der jetzt detektierten Bewegung entsprechendes Signal wird über den Signalanschluß 34 des Meßkanals 32 an eine übergeordnete Schaltung oder dergleichen weitergeleitet. Diese übergeordnete Schaltung kann gleichzeitig nach Abschluß der Bewegungserkennung ein Resetsignal generieren, das dazu führt, dass die Umschalter 18 und 24 wieder den magnetoresistiven Sensor 12 in dessen Bereitschaftszustand schalten. Dies kann beispielsweise durch einen hier angedeuteten Rücksetzanschluß 46 am Auslösemittel 40 erfolgen.

Die Erfindung beschränkt sich nicht auf das dargestellte Ausführungsbeispiel. So kann das Prinzip der Umschaltung der Versorgungsspannungsquelle auch beispielsweise bei kapazitiven Sensoren, induktiven Sensoren, Dehnmeßstreifen aufweisenden Sensoren oder dergleichen eingesetzt werden.

### BEZUGSZEICHENLISTE

- 100: Schaltungsanordnung
- 12: magnetoresistiver Sensor
- 14: Versorgungspannungsquelle
- 16: Auswerteschaltung
- 18: erster Umschalter
- 20: Eingangsanschlüsse
- 22: Ausgangsanschlüsse
- 24: zweiter Umschalter
- 26: erste Stromquelle
- 28: zweite Stromquelle
- 30: erster Messkanal
- 32: zweiter Messkanal
- 34: Signalanschluss
- 36: Ausgangsanschluss
- 38: Eingangsanschluss
- 40: Auslösemittel
- 42: Steueranschluss
- 44: Steueranschluss
- 46: Rücksetzanschluss

## Patentansprüche

1. Schaltungsanordnung zur Steuerung eines Sensors mit einer Versorgungsspannungsquelle, die mit Eingangsanschlüssen des Sensors verbunden ist, und eine Auswerteschaltung, die mit Ausgangsanschlüssen des Sensors verbunden ist, wobei die Versorgungsspannungsquelle (14) zwischen wenigstens zwei Strompegeln in Abhängigkeit eines Ausgangssignalpegels (S) des Sensors (12) umschaltbar ist,
**dadurch gekennzeichnet,**
**dass** die Versorgungsspannungsquelle (14) wenigstens zwei Stromquellen (26, 28) umfaßt, die über einen Umschalter (18) mit dem Sensor (12) verbunden sind, wobei ein Steueranschluß (42) des Umschalters (18) von der Auswerteschaltung (16) des Sensors (12) ansteuerbar ist und die Auswerteschaltung (16) wenigstens zwei Meßkanäle (30, 32) unterschiedlicher Empfindlichkeit umfaßt, wobei ein Meßkanal (30), der einen Hochpaßfilter für das Sensorsignal (S) umfasst, mit niedrigerer Empfindlichkeit der Ansteuerung des Umschalters (18) dient.

2. Schaltungsanordnung nach Anspruch 1,
**dadurch gekennzeichnet,**
**dass** der Meßkanal (30) mit niedrigerer Empfindlichkeit gleichzeitig der Umschaltung der Auswerteschaltung (16) auf den Meßkanal (32) mit höherer Empfindlichkeit dient.

3. Schaltungsanordnung nach Anspruch 1 oder 2,
**dadurch gekennzeichnet,**
**dass** die Ausgangsanschlüsse (22) des Sensors (12) über einen zweiten Umschalter (24) mit der Auswerteschaltung (16) verbunden sind.

4. Schaltungsanordnung nach einem der vorhergehenden Ansprüche,
**dadurch gekennzeichnet,**
**dass** der erste Umschalter (18) und der zweite Umschalter (24) von einem gemeinsamen Auslösemittel (40) ansteuerbar sind.

5. Schaltungsanordnung nach Anspruch 4,
**dadurch gekennzeichnet,**
**dass** das Auslösemittel (40) ein Schmitt-Trigger ist, der von dem Meßkanal (30) mit niedrigerer Empfindlichkeit ansteuerbar ist.

6. Sensor,
**gekennzeichnet durch**
eine Schaltungsanordnung nach wenigstens einem der Ansprüche 1 bis 5.

7. Sensor nach Anspruch 6,
**dadurch gekennzeichnet,**
**dass** der Sensor (12) ein magnetoresistiv, kapazitiv, induktiv und/oder mechanisch wirkender Sensor ist.

## Claims

1. A circuit arrangement for controlling a sensor, the circuit arrangement comprising a supply voltage source which is connected to input terminals of the sensor, and an evaluation circuit which is connected to output terminals of the sensor, which supply voltage source (14) can be switched between at least two power levels in dependence on an output signal level (S) of the sensor (12), **characterized in that** the supply voltage source (14) comprises at least two power sources (26, 28) which are connected to the sensor (12) via a switch (18), wherein a control terminal (42) of the switch (18) can be triggered by the evaluation circuit (16) of the sensor (12) and the evaluation circuit (16) comprises at least two measuring channels (30, 32) having different sensitivities, wherein one measuring channel (30) comprising a high-pass filter for the sensor signal (S) and having lower sensitivity is used for triggering the switch (18).

2. A circuit arrangement as claimed in claim 1, **characterized in that** the measuring channel (30) having the lower sensitivity at the same time serves to switch the evaluation circuit (16) to the measuring channel (32) having the higher sensitivity.

3. A circuit arrangement as claimed in claim 1 or 2, **characterized in that** the output terminals (22) of the sensor (12) are connected to the evaluation circuit (16) via a second switch (24).

4. A circuit arrangement as claimed in any one of the preceding claims, **characterized in that** the first switch (18) and the second switch (24) can be triggered by a common trigger means (40).

5. A circuit arrangement as claimed in claim 4, **characterized in that** the trigger means (40) is a Schmitt trigger which can be triggered by the measuring channel (30) having the lower sensitivity.

6. A sensor, **characterized by** a circuit arrangement as claimed in at least one of claims 1 to 5.

7. A sensor as claimed in claim 6, **characterized in that** the sensor (12) is a magnetoresistive, capacitive, inductive and/or mechanically operating sensor.

## Revendications

1. Circuit d'attaque pour la commande d'un capteur avec une source de tension d'alimentation qui est raccordée aux connexions d'entrée du capteur et un circuit d'évaluation qui est raccordé aux connexions d'entrée du capteur, tandis que la source de tension d'alimentation (14) peut être permutée entre au moins deux niveaux de courant en fonction d'un niveau de signal de sortie (S) du capteur (12),
**caractérisé en ce que**
la source de tension d'alimentation (14) comprend au moins deux sources de courant (26, 28) qui sont connectées au capteur (12) par l'intermédiaire d'un commutateur inverseur (18), tandis qu'une connexion de commande (42) du commutateur inverseur (18) peut être pilotée par le circuit d'évaluation (16) du capteur et le circuit d'évaluation (16) comprend au moins deux canaux de mesure (30, 32) de sensibilité différente, tandis qu'un canal de mesure (30), qui comprend un filtre passe-haut pour le signal de capteur (S), sert au pilotage du commutateur inverseur (18) avec une plus faible sensibilité.

2. Circuit d'attaque selon la revendication 1,
**caractérisé en ce que**
le canal de mesure (30) avec une plus faible sensibilité sert à la commutation du circuit d'évaluation (16) sur le canal de mesure (32) de plus haute sensibilité.

3. Circuit d'attaque selon la revendication 1 ou 2,
**caractérisé en ce que**
les connexions de sortie (22) du capteur (12) sont connectées au circuit d'évaluation (16) par l'intermédiaire d'un second commutateur inverseur (24).

4. Circuit d'attaque selon l'une des revendications précédentes,
**caractérisé en ce que**
le premier commutateur inverseur (18) et le second commutateur inverseur (24) peuvent être pilotés par un moyen de déclenchement commun (40).

5. Circuit d'attaque selon la revendication 4,
**caractérisé en ce que**
le moyen de déclenchement (40) est une gâchette Schmitt qui peut être pilotée par le canal de mesure (30) de plus faible sensibilité.

6. Capteur,
**caractérisé par**
un circuit d'attaque selon au moins l'une des revendications 1 à 5.

7. Capteur selon la revendication 6,
**caractérisé en ce que**
le capteur (12) est un capteur opérant de façon magnétorésistive, capacitive, inductive et/ou mécanique.
